# FASCICULE DE BREVET EUROPEEN

(11) **EP 0 549 393 B1**
(45) Date de publication et mention de la délivrance du brevet: **28.02.1996**
(21) Numéro de dépôt: 92403338.4
(22) Date de dépôt: 09.12.1992
(51) Int. Cl.: H05K 3/00, B29C 63/00, G03F 7/16, H05K 3/22

(54) **Procédé et dispositif pour enlever les pellicules protectrices de flans insolés de circuit imprimé**
Verfahren und Anordnung zum Entfernen von Schutzfilmen von isolierten Platinen mit gedruckten Schaltungen
Method and device for removing protective films from insulated boards of printed circuits

(30) Priorité: 12.12.1991 FR 9115457
(43) Date de publication de la demande: 30.06.1993
(73) Titulaire: CIRCEE, F-49300 Cholet (FR)
(72) Inventeur: Le Dortz, Francis P., F-49280 Saint Léger s/s Cholet (FR)
(74) Mandataire: Hasenrader, Hubert

(56) Documents cités:
- EP-A- 0 218 873
- DE-A- 2 942 249

## Description

La présente invention concerne le domaine de la fabrication de circuits imprimés.

Elle concerne plus précisément un procédé et un dispositif pour enlever par pelage les pellicules protectrices recouvrant les faces supérieure et inférieure d'un flan de circuit imprimé après la phase d'insolation dudit flan et avant la phase de développement.

Une des gammes de fabrication d'un circuit imprimé comporte les phases suivantes :
le débitage du flan à partir d'une plaque de support composée d'un substrat présentant sur chaque face, une couche de cuivre laminée et collée ; le perçage dudit flan ; la photogravure ; la gravure ; la découpe ; et le contrôle du circuit imprimé obtenu.

La photogravure comporte quatre opérations successives le laminage, l'insolation, le dépelliculage et le développement.

Le laminage est l'opération qui consiste à déposer sur chaque couche de cuivre du flan, un film photosensible appelé "photorésist" ou "film sec". Ce film est appliqué à chaud et sous pression et il est protégé par une pellicule protectrice, du type connu sous le nom de marque "Mylar".

L'insolation consiste à émettre un rayonnement ultra-violet de forte puissance sur le film sec et à travers un masque opaque en dehors de l'image du circuit imprimé à réaliser. L'action des rayons ultra-violets a pour but de polymériser ou durcir les parties du film ayant reçu le rayonnement.

Le dépelliculage consiste à enlever les deux pellicules de protection. Cette opération est le plus souvent réalisée manuellement à l'aide d'un cutter.

Le développement permet de dissoudre avec un produit adapté, toutes les parties du film sec qui n'ont pas reçu le rayonnement ultra-violet pour découvrir une partie des couches de cuivre qui sera ensuite enlevée par un agent chimique dans la phase de gravure.

Actuellement il existe dans le commerce des équipements permettant d'automatiser d'une part, le laminage et l'insolation, et, d'autre part, le développement et la gravure. Mais il existe une rupture dans les lignes de fabrication de fait de l'opération manuelle de dépelliculage des flans insolés. De plus, dans cette opération manuelle, on enlève les deux pellicules l'une après l'autre, ce qui peut entraîner des contraintes préjudiciables par suite de la déformation subie par le flan à l'arrachage de chaque pellicule notamment sur les ciruits imprimés avant une épaisseur inférieure à 0,8 mm. Ep-A-0 218 873 décrit un appareil et un procédé pour enlever par pelage des couches de protection d'un flan de circuit imprimé. Dans une première étape un bord avant de chaque couche est soulevé par une brosse tournante ou par un tranchant mobil. Ensuite le flan est transporté dans une chambre comprenant deux rampes pour injecter de l'eau sous pression sous un angle oblique à chaque bord avant pour enlever les couches du flan.

Le but de la présente invention est de pallier ces inconvénients, et de proposer un procédé pour enlever les pellicules après insolation des flans et un dispositif pour mettre en oeuvre le procédé, qui puisse facilement être intégré dans la ligne de fabrication.

Selon le procédé de l'invention, on projette un jet d'eau sous pression contre un bord dudit flan, perpendiculairement audit bord et dans le plan général dudit flan, de manière à décoller les zones des deux pellicules qui sont au voisinage dudit bord et on exerce ensuite une force de traction sur lesdites deux zones de pellicule décollées de manière à enlever lesdites pellicules en même temps et de manière symétrique par pelage.

Avantageusement on entraîne ledit flan pendant l'opération de pelage au moyen de deux rouleaux transporteurs contrarotatifs disposés de part et d'autre dudit flan. On projette ledit jet d'eau sous pression lorsque ledit bord de flan est engagé entre lesdits rouleaux transporteurs de telle manière que les deux zones de pellicule décollées par le jet d'eau sous pression viennent se plaquer respectivement sur les parois desdits rouleaux transporteurs.

On exerce une force de traction sur lesdites deux zones de pellicule décollées au moyen de deux rouleaux presseurs coopérant respectivement avec lesdits rouleaux transporteurs, chaque rouleau presseur étant disposé de manière à maintenir par pincement la partie décollée de la pellicule correspondante, comprise entre la génératrice du rouleau transporteur en contact avec ledit flan et la génératrice du rouleau transporteur en contact avec ledit rouleau presseur, contre la paroi du rouleau transporteur correspondant.

Grâce au procédé proposé, les deux pellicules sont enlevées de manière symétrique et en même temps.

Le dispositif pour mettre en oeuvre le procédé de l'invention comporte :
des moyens pour alimenter en séquence des flans insolés,
un chemin de passage pour la circulation des flans délivrés par lesdits moyens d'alimentation,
deux rouleaux transporteurs disposés respectivement au-dessus et au-dessous dudit chemin de passage et destinés à entraîner lesdits flans,
des moyens pour projeter un jet d'eau sous pression contre le bord avant du flan engagé entre lesdits rouleaux transporteurs de manière à décoller les zones desdites deux pellicules, qui sont voisines dudit bord de flan, et à plaquer lesdites deux zones décollées respectivement contre les parois desdits rouleaux transporteurs,
deux rouleaux presseurs situés à distance de part et d'autre dudit chemin de passage et en aval desdits rouleaux transporteurs, chacun desdits rouleaux presseurs coopérant avec un rouleau transporteur pour maintenir par pincement au moins une partie décollée de la pellicule correspondante contre la paroi dudit rouleau transporteur de manière à exercer une force de traction permettant d'enlever ladite pellicule par pelage,
des moyens pour évacuer les pellicules enlevées,
des moyens de séchage du flan après enlèvement desdites pellicules,
des moyens d'évacuation du flan après séchage, et
des moyens de commande et de synchronisme.

Avantageusement les moyens pour projeter un jet d'eau sous pression comportent une rampe d'injection alimentée par une source d'eau sous pression et montée entre les rouleaux transporteurs et les moyens de séchage de telle manière qu'elle soit mobile verticalement entre une position d'injection dans laquelle ladite rampe est située dans le plan du chemin de passage et une position de dégagement dans laquelle le chemin de passage est libéré pour permettre la circulation du flan dépelliculé vers le poste de séchage.

D'autres avantages et caractéristiques de l'invention ressortiront à la lecture de la description suivante faite à titre d'exemple et en référence aux dessins annexés dans lesquels :
la figure 1 montre un schéma de principe de la machine à enlever les pellicules d'un flan de circuit imprimé selon le procédé de l'invention,
la figure 2 montre à plus grande échelle le principe de l'amorçage du décollement des pellicules selon le procédé de l'invention, et
la figure 3 montre à plus grande échelle le principe du pelage des pellicules, celles-ci étant pincées entre les rouleaux transporteurs et les rouleaux presseurs.

Le dessin montre un mode de réalisation d'un dispositif 1 pour enlever les pellicules protectrices 2a, 2b recouvrant les faces supérieure 3b et inférieure 3a d'un flan 4 de circuit imprimé préalablement insolé, selon le procédé de l'invention.

Ce dispositif est susceptible d'être intégré dans une ligne de fabrication de circuits imprimés et disposé entre un équipement d'insolation A situé en amont et un équipement de développement B situé en aval.

Ce dispositif comporte essentiellement, d'amont en aval, des moyens pour alimenter en séquence des flans insolés 4, qui peuvent faire partie de l'équipement d'insolation A, un chemin de passage 5 horizontal permettant la circulation du flan 4 entre l'équipement d'insolation A et l'équipement de développement B, des moyens pour entraîner les flans 4 le long du chemin de passage 5, des moyens pour enlever les pellicules 2a, 2b, des moyens pour évacuer les pellicules enlevées, et des moyens pour tranférer les flans dépelliculés vers l'équipement de développement B. Il comporte de plus des moyens de commande et de synchronisme.

Des jeux de rouleaux 6 disposés au-dessus et au-dessous du chemin de passage 5 constituent les moyens pour entraîner les flans 4.

Les moyens pour enlever les pellicules comportent deux rouleaux transporteurs contrarotatifs 7a, 7b disposés respectivement au-dessus et au-dessous du chemin de passage 5, deux rouleaux presseurs 8a, 8b situés à distance et de part et d'autre du chemin de passage 5 et des moyens pour projeter un jet d'eau sous pression contre le bord avant 9 d'un flan 4 lorsque ce bord avant 9 est engagé entre les deux rouleaux transporteurs 7a, 7b.

Les rouleaux transporteurs 7a, 7b et éventuellement les rouleaux 6 sont entraînés en rotation par des dispositifs d'entraînement connus.

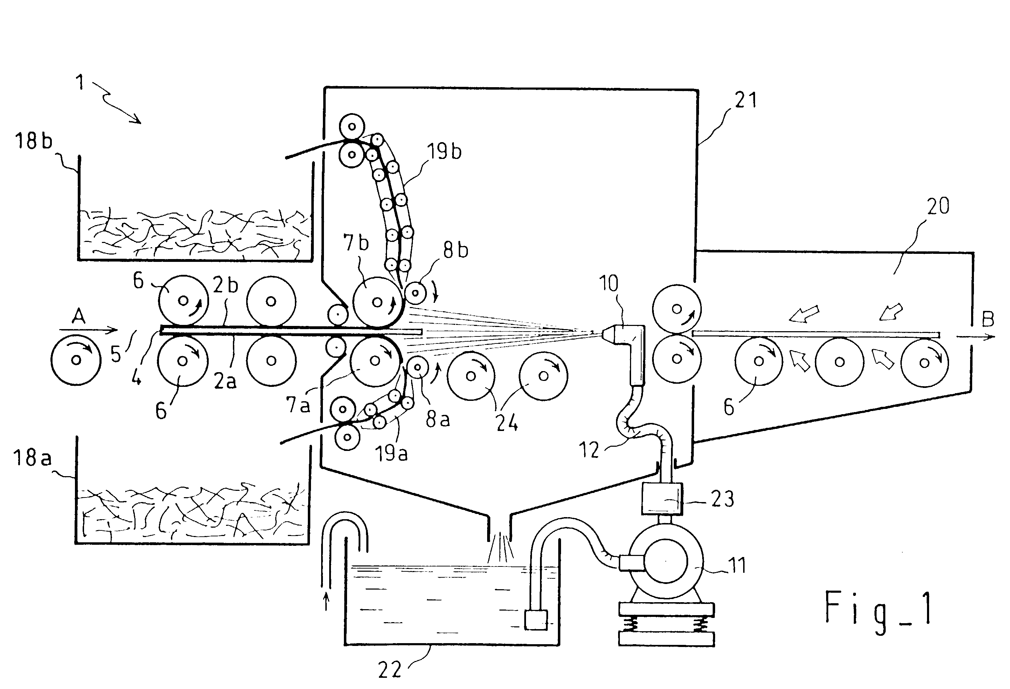

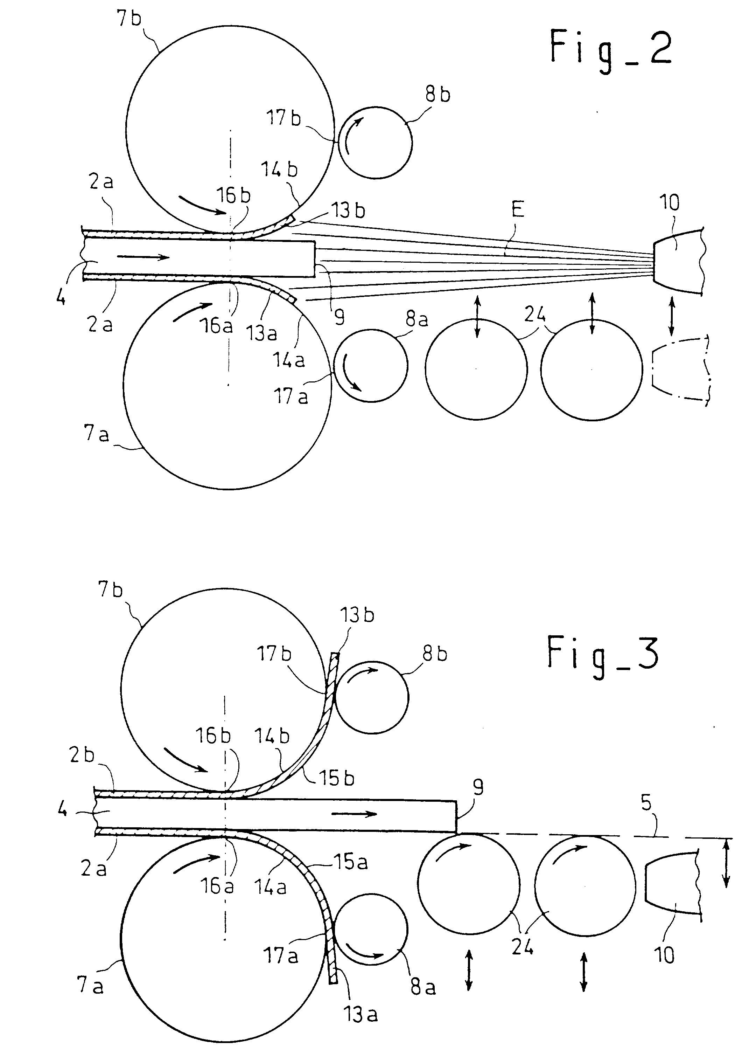

Les moyens pour injecter de l'eau sous pression comprennent une rampe d'injection 10 alimentée par une pompe à haute pression 11, au moyen d'un tube flexible 12. La rampe d'injection 10 est mobile verticalement entre une position d'injection, représentée sur les figures 1 et 2, dans laquelle, la rampe d'injection 10 est disposée dans le plan général du chemin de passage 5, en aval des rouleaux transporteurs 7a, 7b et dirige le jet d'eau sous pression E vers le bord avant 9 du flan 4 de manière à décoller les zones avant 13a, 13b des pellicules 2a, 2b et à les plaquer contre les parois 14a et 14b des rouleaux transporteurs 7a, 7b, et une position de dégagement, représentée sur la figure 3, dans laquelle le chemin de passage 5 est dégagé pour permettre la circulation du flan 4 dépelliculé.

Les rouleaux presseurs 8a, 8b coopèrent respectivement avec les rouleaux transporteurs 7a, 7b et ils sont disposés en aval de ces derniers et symétriquement par rapport au chemin de passage 5.

Lors de l'avancement du flan 4 engagé entre les rouleaux transporteurs 7a, 7b les extrémités des zones avant de pellicule 13a, 13b qui ont été décollées par le jet d'eau E et qui sont plaquées contre les parois 14a, 14b viennent s'engager respectivement entre les rouleaux transporteurs 7a, 7b et les rouleaux presseurs 8a, 8b. Les rouleaux presseurs 8a, 8b maintiennent alors par pincement les parties décollées de pellicule 15a, 15b, comprises entre les génératrices 16a, 16b des rouleaux transporteurs 7a, 7b en contact avec le flan 4 et les génératrices 17a, 17b communes aux rouleaux transporteurs 7a, 7b et aux rouleaux presseurs 8a, 8b, contre les parois 14a, 14b des rouleaux transporteurs 7a, 7b. La rampe d'injection 10 peut alors passer dans la position de dégagement et le débit d'eau peut être arrêté.

La force de pincement exercée par les rouleaux presseurs 8a, 8b contre les rouleaux transporteurs 7a, 7b est suffisante pour poursuivre et achever l'enlèvement des pellicules 2a, 2b par pelage lors de la circulation du flan 4 entre les rouleaux transporteurs 7a, 7b.

Les pellicules enlevées 2a, 2b sont évacuées vers des bacs amovibles 18a, 18b par des moyens d'évacuation comportant des transporteurs 19a, 19b à courroies plates crantées intérieurement.

Après le dépelliculage, le flan humide passe dans une chambre de séchage 20 comportant une soufflerie puissante qui souffle de l'air chaud à une température de 50° C environ, avant d'être transféré vers le dispositif de développement B.

Les rouleaux transporteurs 7a, 7b, les rouleaux presseurs 8a, 8b, les transporteurs 19a, 19b et la rampe d'injection 10 sont enfermés dans une enceinte 21 munie de moyens de récupération par gravité de l'eau projetée par la rampe d'injection 10. L'eau est récupérée dans un bac de réserve d'eau 22 d'où elle est pompée par la pompe 11. Une cartouche filtrante 23 est prévue à la sortie de la pompe 11.

Des rouleaux 24 mobiles verticalement sont intercalés entre le rouleau transporteur inférieur 7a et la rampe d'injection 10 sous le chemin de passage 5. Ces rouleaux 24 sont en position haute lorsque la rampe d'injection 10 est en position de dégagement et en position basse lorsque la rampe d'injection 10 est en position d'injection.

Les moyens de commande et de synchronisme comportent notamment un dispositif de détection du flan 4 au voisinage des rouleaux transporteurs 7a, 7b qui permet de commander le déplacement des rouleaux 24 vers le bas, et le déplacement de la rampe d'injection 10 vers le haut, ainsi que la mise en place du jet d'eau E sous pression dans l'axe de l'épaisseur du flan 4, un dispositif de détection de fin de course haut, placé sur le mécanisme de déplacement de la rampe d'injection 10, qui déclenche une surpression du débit d'eau fournie par la pompe 12, et un dispositif de temporisation qui provoque l'arrêt du jet d'eau E, le déplacement vers le haut des rouleaux 24 et le déplacement vers le bas de la rampe d'injection 10.

De préférence, les rouleaux presseurs 8a et 8b sont entraînés par friction respectivement par les rouleaux transporteurs 7a et 7b. Les rouleaux 6 situés en-dessous du chemin de passage 5 sont moteurs et transporteurs. En revanche, les rouleaux 6 situés au-dessus de chemin de passage 5 sont presseurs et ils sont montés mobiles verticalement, la pression étant exercée par le poids desdits rouleaux ou par des moyens élastiques appropriés. De même, l'ensemble constitué par le rouleau transporteur supérieur 7b, le rouleau presseur supérieur 8b et le transporteur supérieur 19b est monté sur un support réglable en hauteur par rapport au chemin de passage 5 pour que le dispositif 1 de l'invention puisse admettre différentes épaisseurs de flans 4.

Les rouleaux transporteurs 7a, 7b peuvent tourner en permanence à une vitesse uniforme et réglable, de manière à entraîner le flan 4 à une vitesse inférieure à 3 m/mm. Le dimensionnement des rouleaux et de la rampe d'injection 10 peut être prévu pour que le dispositif puisse enlever les pellicules de flans ayant une largeur de 550 mm ou plus. Le dispositif 1 de l'invention permet de traiter des flans de différentes longueurs et de différentes épaisseurs. Le temporisateur peut être réglable entre 0 et 10 secondes . Le temps nécessaire pour décoller les zones avant 13a et 13b est compris entre 2 et 3 secondes lorsque la vitesse de défilement du flan 4 est de 1,20 mètre par minute.

## Revendications

1. Procédé pour enlever par pelage les pellicules protectrices (2a, 2b) recouvrant les faces supérieure (3b) et inférieure (3a) d'un flan (4) de circuit imprimé en cours d'élaboration, après la phase d'insolation dudit flan et avant la phase de développement, caractérisé
en ce qu'on projette un jet d'eau (E) sous pression contre un bord (9) dudit flan (4) perpendiculairement audit bord (9) et dans le plan général dudit flan (4) de manière à décoller les zones (13a, 13b) desdites deux pellicules (2a, 2b), qui sont voisines dudit bord (9) de flan, et
en ce qu'on exerce ensuite une force de traction sur lesdites deux zones de pellicule (13a, 13b) décollées de manière à enlever lesdites pellicules (2a, 2b) en même temps et de manière symétrique par pelage.

2. Procédé selon la revendication 1, caractérisé en ce qu'on entraîne ledit flan (4) pendant l'opération de pelage au moyen de deux rouleaux transporteurs contrarotatifs (7a, 7b) disposés de part et d'autre dudit flan (4),
en ce qu'on projette ledit jet d'eau (E) sous pression lorsque ledit bord de flan (9) est engagé entre lesdits rouleaux transporteurs (7a, 7b) de telle manière que les deux zones pellicules (13a, 13b) décollées par le jet d'eau sous pression viennent se plaquer respectivement sur les parois (14a, 14b) desdits rouleaux transporteurs (7a, 7b), et
en ce qu'on exerce ensuite une force de traction sur lesdites deux zones de pellicule décollées (13a, 13b) au moyen de deux rouleaux presseurs (8a, 8b) coopérant respectivement avec lesdits rouleaux transporteurs (7a, 7b), chaque rouleau presseur (8a, 8b) étant disposé de manière à maintenir par pincement la partie décollée (14a, 14b) de la pellicule correspondante (2a, 2b), comprise entre la génératrice (16a, 16b) du rouleau transporteur (7a, 7b) en contact avec ledit flan (4) et la génératrice (17a, 17b) du rouleau transporteur (7a, 7b) en contact avec ledit rouleau presseur (8a, 8b), contre la paroi (14a, 14b) du rouleau transporteur (7a, 7b) correspondant.

3. Dispositif pour enlever par pelage les pellicules protectrices (2a, 2b) recouvrant les faces supérieure (3b) et inférieure (3a) d'un flan (4) de circuit imprimé en cours d'élaboration, après la phase d'insolation dudit flan (4) et avant la phase de développement comportant
des moyens (A) pour alimenter en séquence des flans insolés (4),
un chemin de passage (5) pour la circulation des flans (4) délivrés par lesdits moyens d'alimentation (A),
deux rouleaux transporteurs (7a, 7b) disposés respectivement au-dessus et au-dessous dudit chemin de passage (5) et destinés à entraîner lesdits flans (4), caractérisé en ce qu'il comporte :
des moyens (10, 11, 12) pour projeter un jet d'eau (E) sous pression contre le bord avant (9) du flan (4) engagé entre lesdits rouleaux transporteurs (7a, 7b) de manière à décoller les zones (13a, 13b) desdites deux pellicules (2a, 2b), qui sont voisines dudit bord de flan (9), et à plaquer lesdites deux zones décollées (13a, 13b) respectivement contre les parois (14a, 14b) desdits rouleaux transporteurs (7a, 7b),
deux rouleaux presseurs (8a, 8b) situés à distance de part et d'autre dudit chemin de passage (5) et en aval desdits rouleaux transporteurs, chacun desdits rouleaux presseurs (8a, 8b) coopérant avec un rouleau transporteur (7a, 7b) pour maintenir par pincement au moins une partie décollée (15a, 15b) de la pellicule correspondante (2a, 2b) contre la paroi dudit rouleau transporteur (7a, 7b) de manière à exercer une force de traction permettant d'enlever ladite pellicule (2a, 2b) par pelage,
des moyens (19a, 19b) pour évacuer les pellicules enlevées,
des moyens de séchage (20) du flan (4) après enlèvement desdites pellicules (2a, 2b),
des moyens d'évacuation du flan (4) après séchage, et
des moyens de commande et de synchronisme.

4. Dispositif selon la revendication 3, caractérisé en ce que les moyens pour projeter un jet d'eau (E) sous pression comportent :
une rampe d'injection (10) alimentée par une source d'eau sous pression (13) et montée entre les rouleaux transporteurs (7a, 7b) et les moyens de séchage (20) de telle manière qu'elle soit mobile verticalement entre une position d'injection dans laquelle ladite rampe (10) est située dans le plan du chemin de passage (5) et une position de dégagement dans laquelle le chemin de passage (5) est libéré pour permettre la circulation du flan dépelliculé (4) vers les moyens de séchage (20).

## Patentansprüche

1. Verfahren zum Entfernen von die Oberseite (3b) und Unterseite (3a) einer Platine (4) einer gedruckten Schaltung während der Herstellung abdeckenden Schutzfilmen (2a, 2b) durch Abziehen nach dem Bestrahlungsschritt der Platine und vor dem Entwicklungsschritt, dadurch gekennzeichnet,
daß ein Wasserstrahl (E) unter Druck in der Hauptebene der Platine (4) und rechtwinklig zu einem Rand (9) der Platine (4) gegen den Rand (9) gespritzt wird, so daß Bereiche (13a, 13b) der zwei Filme (2a, 2b), die dem Rand (9) der Platine benachbart sind, abgelöst werden, und
daß anschließend eine Zugkraft auf die zwei abgelösten Bereiche (13a, 13b) der Filme ausgeübt wird, so daß die Filme (2a, 2b) gleichzeitig und symmetrisch durch Abziehen entfernt werden.

2. Verfahren nach Anspruch 1, dadurch gekennzeichnet, daß die Platine (4) während des Abziehvorganges mittels zweier gegensinnig drehender Transportrollen (7a, 7b) mitgenommen wird, die beidseits der Platine (4) angeordnet sind,
daß der Wasserstrahl (E) unter Druck verspritzt wird, wenn der Rand (9) der Platine im Eingriff zwischen den Transportrollen (7a, 7b) ist, so daß die zwei durch den Wasserstrahl unter Druck abgelösten Bereiche (13a, 13b) der Filme sich jeweils an den Umfang (14a, 14b) der Transportrollen (7a, 7b) anlegen, und daß anschließend mittels zweier Druckrollen (8a, 8b), die mit den Transportrollen (7a bzw. 7b) zusammenwirken, eine Zugkraft auf die zwei abgelösten Filmbereiche (13a, 13b) ausgeübt wird, wobei jede Druckrolle (8a, 8b) so angeordnet ist, daß sie den abgelösten Teil (14a, 14b) des entsprechenden Films (2a, 2b), der sich zwischen der Mantellinie (16a, 16b) der Transportrolle (7a, 7b) in Berührung mit der Platine (4) und der Mantellinie (17a, 17b) der Transportrolle (7a, 7b) in Berührung mit der Druckrolle (8a, 8b) befindet, durch Klemmen gegen den Umfang (14a, 14b) der entsprechenden Transportrolle (7a, 7b) hält.

3. Vorrichtung zum Entfernen von die Oberseite (3b) und Unterseite (3a) einer Platine (4) einer gedruckten Schaltung während der Herstellung abdeckenden Schutzfilmen (2a, 2b) durch Abziehen nach dem Bestrahlungsschritt der Platine und vor dem Entwicklungsschritt, mit
Mitteln (A) zum aufeinanderfolgenden Zuführen bestrahlter Platinen (4),
einer Durchgangsbahn (5) für den Fluß der durch die Zuführmittel (A) gelieferten Platinen (4),
zwei Transportrollen (7a, 7b), die oberhalb bzw. unterhalb der Durchgangsbahn (5) angeordnet und zum Mitnehmen der Platinen (4) bestimmt sind, dadurch gekennzeichnet, daß sie aufweist:
Mittel (10, 11, 12) zum Verspritzen eines Wasserstrahles (E) unter Druck gegen den vorderen Rand (9) der Platine (4), der sich im Eingriff zwischen den Transportrollen (7a, 7b) befindet, so daß Bereiche (13a, 13b) der Filme (2a, 2b), die dem Rand (9) der Platine benachbart sind, abgelöst werden und die zwei abgelösten Bereiche (13a, 13b) an den Umfang (14a, 14b) der entsprechenden Transportrolle (7a, 7b) angelegt werden,
zwei Druckrollen (8a, 8b), die in einem Abstand von der Durchgangsbahn (5) beidseits derselben und stromabwärts der Transportrollen angeordnet sind, wobei jede der Druckrollen (8a, 8b) mit einer Transportrolle (7a, 7b) zusammenwirkt, um durch Quetschen zumindest einen abgelösten Teil (15a, 15b) des entsprechenden Films (2a, 2b) gegen den Umfang der Transportrolle (7a, 7b) zu halten, so daß eine Zugkraft ausgeübt wird, die ein Entfernen des Films (2a, 2b) durch Abziehen ermöglicht,
Mittel (19a, 19b) zum Abführen der entfernten Filme,
eine Einrichtung (20) zum Trocknen der Platine (4) nach einer Entfernung der Filme (2a, 2b),
Mittel zum Abführen der Platine (4) nach einer Trocknung, und
Antriebs- und Synchronisiermittel.

4. Vorrichtung nach Anspruch 3, dadurch gekennzeichnet, daß die Mittel zum Verspritzen eines Wasserstrahles (E) unter Druck eine von einer Wasserquelle (13) unter Druck gespeiste Spritzleitung (10) aufweisen, die zwischen den Transportrollen (7a, 7b) und der Trocknungseinrichtung (20) so angebracht ist, daß sie vertikal zwischen einer Spritzstellung, in der die Leitung (10) in der Ebene der Durchgangsbahn (5) angeordnet ist, und einer Freigabestellung bewegbar ist, in der die Durchgangsbahn (5) freigegeben ist, um einen Transport einer Platine (4), bei der die Filme entfernt worden sind, zur Trocknungseinrichtung (20) zu erlauben.

## Claims

1. Process for removing by peeling the protective films (2a, 2b) covering the upper (3b) and lower faces (3a) of a printed circuit board (4) during construction, after the exposure phase of the said board (4) and before the development phase, characterised in that a jet of water (E) is discharged under pressure against an edge (9) of the said board (4), perpendicularly to the said edge (9) and in the common plane of the said board (4) so as to unstick the areas (13a, 13b) of the said two films (2a, 2b) which adjoin the said edge (9) of the board, and that subsequently a traction force is applied to the said two areas of unstuck film (13a, 13b) so as to remove the said films (2a, 2b) at the same time and in symmetrical manner by peeling.

2. Process according to claim 1, characterised in that during the peeling operation the said board (4) is pulled along by means of two counter-rotating transport rollers (7a, 7b) arranged on both sides of the said board, that the said jet of water (E) is discharged under pressure when the said edge of the board (9) is engaged between the said transport rollers (7a, 7b) in such a way that the two areas of film (13a, 13b) unstuck by the jet of water under pressure come to attach themselves to the respective surfaces (14a, 14b) of the said transport rollers (7a, 7b), and that subsequently a traction force is applied to the said two areas of unstuck film (13a, 13b) by means of two pressure rollers (8a, 8b) each working together respectively with the said transport rollers (7a, 7b), each pressure roller (8a, 8b) being arranged so as to hold the unstuck part (14a, 14b) of the corresponding film (2a, 2b), contained between the generatrix (16a, 16b) of the transport roller (7a, 7b) in contact with the said board (4) and the generatrix (17a, 17b) of the transport roller (7a, 7b) in contact with the said pressure roller, by trapping it against the surface (14a, 14b) of the corresponding transport roller (7a, 7b).

3. Device for removing by peeling the protective films (2a, 2b) covering the upper (3b) and lower faces (3a) of a printed circuit board (4) during construction, after the exposure phase of the said board (4) and before the development phase, comprising:
- means (A) for feeding the exposed boards (4) in sequence,
- a passage way (5) for the movement of the boards (4) supplied by the said feeder means (A),
- two transport rollers (7a, 7b) arranged respectively above and below the said passage way (5) and intended to pull the said boards (4) along,
characterised in that it comprises:
- means (10, 11, 12) for discharging a jet of water (E) under pressure against the front edge (9) of the board (4) engaged between the said transport rollers (7a, 7b) so as to unstick the areas (13a, 13b) of the said two films (2a, 2b), which adjoin the said edge of the board (9), and to attach the said two unstuck areas (13a, 13b) respectively against the surfaces (14a, 14b) of the said transport rollers (7a, 7b),
- two pressure rollers (8a, 8b) located at a distance on both sides of the said passage way (5) and downstream of the said transport rollers, each of the said pressure rollers (8a, 8b) working together with a transport roller (7a, 7b) to hold at least one unstuck part (15a, 15b) of the corresponding film (2a, 2b) by trapping it against the surface of the said transport roller (7a, 7b) so as to exercise a traction force permitting the removal of the said film (2a, 2b) by peeling,
- means (19a, 19b) for evacuation of the removed films,
- means for drying (20) the board (4) after removal of the said films (2a, 2b),
- means for evacuating the board (4) after drying, and means for control and synchronisation.

4. Device according to claim 3, characterised in that the means for discharging a jet of water (E) under pressure comprise:
an injection head (10) fed by a source of water under pressure (13) and mounted between the transport rollers (7a, 7b) and the drying means (20) in such a way that it can be moved vertically between an injection position in which the said head (10) is located in the plane of the passage way (5) and a release position in which the passage way (5) is freed to allow the movement of the board (4) stripped of film towards the drying means (20).
